(19) Europäisches Patentamt
European Patent Office
Office européen des brevets

(11) **EP 2 089 731 B1**

(12) **EUROPEAN PATENT SPECIFICATION**

(45) Date of publication and mention
of the grant of the patent:
**05.05.2010 Bulletin 2010/18**

(21) Application number: **07826866.1**

(22) Date of filing: **25.10.2007**

(51) Int Cl.:
***G01R 31/36*** *(2006.01)*

(86) International application number:
**PCT/IB2007/054344**

(87) International publication number:
**WO 2008/053410 (08.05.2008 Gazette 2008/19)**

(54) **APPARATUS AND METHOD FOR DETERMINATION OF THE STATE-OF-CHARGE OF A BATTERY WHEN THE BATTERY IS NOT IN EQUILIBRIUM**

VORRICHTUNG UND VERFAHREN ZUR BESTIMMUNG DES LADESTATUS EINER NICHT ÄQUILIBRIERTEN BATTERIE

APPAREIL ET PROCÉDÉ POUR DÉTERMINER L'ÉTAT DE CHARGE D'UNE BATTERIE LORSQUE LA BATTERIE N'EST PAS EN ÉQUILIBRE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **30.10.2006 EP 06123132**

(43) Date of publication of application:
**19.08.2009 Bulletin 2009/34**

(73) Proprietor: **Koninklijke Philips Electronics N.V.**
**5621 BA Eindhoven (NL)**

(72) Inventors:
• **BERGVELD, Hendrik, J.**
**NL-5656 AE Eindhoven (NL)**

• **POP, Valer**
**NL-5656 AE Eindhoven (NL)**
• **NOTTEN, Petrus, H., L.**
**NL-5656 AE Eindhoven (NL)**

(74) Representative: **Van Velzen, Maaike Mathilde**
**Philips**
**Intellectual Property & Standards**
**P.O. Box 220**
**5600 AE Eindhoven (NL)**

(56) References cited:
**EP-A- 1 643 260        WO-A-2006/098594**
**US-A1- 2004 128 086**

## Description

FIELD OF THE INVENTION

Accurate and reliable State-of-Charge (SoC) indication is an important feature on any device powered by rechargeable batteries. With an accurate and reliable SoC indication a user will use all available battery capacity, which will prevent unnecessary recharges that would lead to earlier battery wear-out. Numerous methods for SoC indication have been published and patented. Basically, these methods can be divided over two groups, i.e. direct measurement and bookkeeping, as is described in the book: H. J. Bergveld, W. S. Kruijt, P. H. L. Notten; "Battery Management Systems - Design by Modelling", Philips Research Book Series, vol. I, Kluwer Academic Publishers, Boston, 2002, ISBN 1-4020-0832-5, and in particular in Chapter 6 of this document.

In case of direct measurement, a battery variable, such as terminal voltage, impedance, or temperature, is measured and based on e.g. a look-up table or function, this measured value is directly translated into an SoC value. The main advantage of this group of methods is the fact that as soon as the SoC indication system is connected to the battery, measurements can start and the SoC can be determined. The main disadvantage of this group of methods is that it is very hard to include all relevant battery behaviour in the look-up table or function. That implies that under user conditions not foreseen in the look-up table or function, the SoC has to be obtained from interpolation or extrapolation of the tabulated data. This leads to inaccuracy of the predicted SoC.

BACKGROUND OF THE INVENTION

US-A-6 420 851 discloses that the so-called Electro-Motive Force (EMF) is a useful battery variable for SoC indication by means of direct measurement. The EMF is the difference in equilibrium potential of the positive and negative electrodes and can be measured at the battery terminals when the battery is in equilibrium, i.e. no external current is flowing and the battery voltage has fully relaxed from the application of previous charge/discharge currents. By measuring the battery voltage under equilibrium conditions the measured voltage value can be translated into the SoC value via an EMF-SoC relation stored in the system. This stored curve can be obtained in a laboratory by the SoC indication system manufacturer in several ways, including interpolation, extrapolation and relaxation. The advantage of the EMF-SoC relationship is that the curve remains unchanged when the battery ages, under the condition that the SoC is plotted on a relative axis, e.g. from 0%-100%. However, this method does not work during external current flow or after current flow before the battery voltage has fully relaxed, since the battery terminal voltage does not equal the EMF in this case.

The basis of the bookkeeping group of methods is coulomb counting, i.e. measuring the current flowing into and out of the battery as accurately as possible and integrating the net current. This would lead to a good indication of SoC in case the battery was a linear capacitor. Unfortunately, this is not the case. For example, stored charge is not available to the user under all conditions, e.g. due to diffusion limitations, and battery charge will slowly decrease when the battery is not in use due to self-discharge. Most of this battery-related behaviour is strongly temperature and SoC-dependent and needs to be accounted for on top of coulomb counting, e.g. by lowering the counter contents dependent on the battery SoC and temperature to account for self-discharge. The main advantage is that in general the amount of tabulated data can be lower than in direct-measurement systems. The main disadvantages are (i) that the system needs to be connected to the battery at all times, (ii) the fact that upon first connection the system does not know the SoC (the starting point of integration has to be programmed) and (iii) the need for calibration points. The latter disadvantage stems from the fact that the system is based on integration in time, which means that measurement errors and errors in the battery behaviour stored in the system will accumulate over time. In case of rechargeable batteries defining accurate calibration points that are encountered often enough during use is a real challenge.

Both in case of a direct-measurement SoC indication system and a bookkeeping SoC indication system the battery behaviour will change over time due to aging. For example, the maximum available battery capacity will decrease over time. The aging process depends strongly on usage conditions, such as applied charge and discharge currents, storage conditions, temperature, etc. To deal with aging, some form of adaptivity needs to be added to the system to update parameter values, such that the SoC predictions remain accurate when the battery ages.

Based on the knowledge described above, Philips research has developed an SoC indication method that combines the advantages of direct measurement and bookkeeping. The main feature of the method is that SoC estimation is performed by means of voltage measurement when the battery is in the so-called equilibrium state and by means of current measurement when the battery is in a non-equilibrium state. In the case of equilibrium no or only a small external current flows and the battery voltage has fully relaxed from previous charges or discharges. As described above, the measured battery voltage is practically equal to the EMF of the battery in equilibrium conditions. Therefore, the EMF method can be applied under these conditions. When the battery is in a non-equilibrium state, the battery is either charged or discharged and the charge withdrawn from or supplied to the battery is calculated by means of current integration. This charge is subtracted from or added to an SoC value calculated earlier.

In addition to estimating the SoC, which is a measure of the amount of charge still present inside the battery, the method also predicts the remaining time-of-use of the application under pre-defined conditions. This is done by estimating the time it will take before the battery voltage will drop below the so-called End-of-Discharge voltage $V_{EoD}$. This is the minimum voltage below which the application will no longer function. In order to estimate this time, the course of the battery voltage is predicted for a chosen load condition based on the present value of the SoC, the stored EMF curve and the so-called overpotential function. When a battery is discharged, its voltage can be found by subtracting the overpotential from the EMF value. The overpotential depends on several factors, including the SoC, current, temperature and time, but also on factors such as the ohmic series resistance of the electrodes.

This SoC indication method has been patented in US-A-6 515 453, and later the method has been extended to incorporate several ways to update parameter values to deal with battery aging, which has also been patented in WO-A-2005085889.

Problems or disadvantages overcome by the invention.

An advantage of the SoC indication method described above is that each time the battery returns to equilibrium, the SoC obtained with coulomb counting during previous charge/discharge cycles can be calibrated based on voltage measurement and application of the EMF method. This is an advantage compared to commercially available bookkeeping systems, which usually only use one or two calibration points, i.e. 'battery full' (determined in the charger) and 'battery empty' (determined when the battery voltage drops below the end-of-discharge voltage under certain conditions), which are not encountered very often. In other words, the proposed system is calibrated more often than existing bookkeeping systems, which leads to more accuracy, while maintaining the advantages of a bookkeeping system.

Another advantage of the SoC indication system described above is the fact that the maximum capacity can be updated without the necessity to impose a full charge/discharge cycle on the battery. Provided that starting from a state of equilibrium, the battery is charged or discharged for a certain minimum amount of charge, after which the battery returns to equilibrium, the maximum capacity can simply be calculated by relating the difference in SoC [%] before and after the charge or discharge step to the absolute amount of charge in [C] discharged from or charged to the battery during the applied charge/discharge step. Existing systems always have to apply a full charge/discharge cycle to determine the maximum available battery capacity.

It is crucial that the SoC indication system can accurately determine that the battery is in equilibrium. If the battery voltage has not stabilized yet and the algorithm enters in equilibrium mode, the battery voltage will be higher (when current has been interrupted after a charge step) or lower (when current has been interrupted after a discharge step) than the EMF, leading to a too high (return from charge step) or too low (return from discharge step) predicted SoC value. When this wrong SoC value is used for calibration, the accuracy of the system is compromised. The same holds for the update of the maximum capacity. For example, when the battery voltage after a discharge step has not fully relaxed when the algorithm returns to the equilibrium state, the SoC predicted when returning to the equilibrium state after application of the discharge step will be too low and the resulting calculated maximum capacity will therefore be too low. This means that the problem with an accurate return to the equilibrium state of the algorithm is described in the above mentioned references.

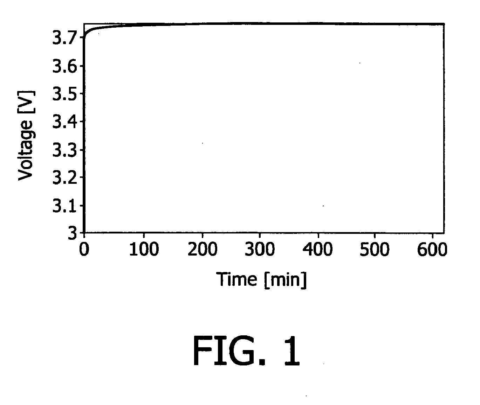

As an illustration the relaxation process of the battery voltage after application of a discharge step is depicted in Figure 1. The figure shows the battery voltage after a discharge step at a 0.25 C-rate at 0% SoC (battery empty) and at 5°C.

The voltage eventually relaxes to a stable value of 3.748 V, i.e. the EMF for this SoC value. After 30 minutes of relaxation, the Open-Circuit Voltage (OCV) still differs 15 mV from the end value. This implies that when the algorithm would return to the equilibrium state after this 30 minutes, the battery voltage would still differ 15 mV from the real EMF, which would translate in a 5% SoC error in this case. Returning to the equilibrium state after 200 minutes would lead to an acceptable SoC error lower than 1% in this case. This also means that in cases like the one illustrated in Figure 1, a system calibration by returning to the equilibrium state can only occur after 200 minutes. If the user starts charging the battery again before these 200 minutes have elapsed, the calibration opportunity is lost. In summary, accurately determining when the battery voltage has stabilized after application of a charge/discharge step is crucial and this may take a long time.

Several methods can be thought of that implement the determination of whether the battery is in equilibrium or not:

1. Fixed time to wait

A simple method is to wait for a fixed amount of time after current interruption and to assume that the battery voltage is stable after this time. In this situation the longest possible, i.e. worst case, relaxation time must be chosen to be sure that the battery is indeed in equilibrium. For low SoC and temperature values this can take a long time, see e.g. Figure 1. Such a long rest period appears very rarely in a portable device. The waiting time can be also chosen as a function of e.g. SoC and temperature but even then, due to e.g. spread between the batteries, false entries into the equilibrium state are likely to happen. Moreover, the system has to wait until the battery has relaxed before the EMF value becomes available and calibration or update of maximum capacity becomes possible.

2. Threshold for the measured dV/dt value

In order to allow the algorithm to change to the equilibrium state, the condition of a stable voltage has to be met. The voltage change in time, i.e. the derivative dV/dt, can be used to determine this: when dV/dt is below a certain threshold value the voltage can be assumed stable and the battery to be in equilibrium. However, under normal conditions the battery never reaches a fully relaxed state because there is always a certain small current present (e.g. in a mobile phone application the standby current). It has been shown that it is very difficult to distinguish between a relaxed and not relaxed battery voltage by only dV/dt measurements. If for all SoC values the same threshold value is used to detect equilibrium (dV/dt<threshold) the chance on false detections seems to be quite high. Another disadvantage of this method is that, as for waiting for a fixed amount of time, the system has to wait until the battery has fully relaxed.

3. Voltage-prediction method predicts relaxation end value

When a model of the voltage relaxation process is available, the relaxation end value, i.e. the EMF, can be calculated based on the relaxation conditions. The main advantage compared to using a fixed waiting time or dV/dt threshold is that the EMF value becomes available before the battery has fully relaxed. This allows the system to calibrate the SoC obtained from prolonged coulomb counting even when the user does not leave enough time for full relaxation between successive charges or discharges. However, of course this imposes strong demands on the accuracy of the predicted relaxation end value.

Of the three described methods to determine whether the battery is in equilibrium the third method is the most advantageous, since it would allow even more calibration opportunities and update opportunities for the maximum battery capacity.

Prior art provides two methods to implement this.

J.H. Aylor, A. Thieme, B.W. Johnson, "A Battery State-of-Charge Indicator for Electric Wheelchairs", IEEE Trans. on industrial electronics, vol. 39, no. 5, pp.398-409, October 1992, discloses a voltage-prediction method in the field of lead-acid batteries. The idea of this method is that a battery OCV recovery curve can be approximated by two asymptotes if plotted on a semi-log scale. It is noted that in order to predict the relaxation end voltage, this method makes use of a fixed parameter found from previous laboratory experiments ($X_p$). In case the battery ages and the voltage relaxation behaviour changes, without an update of this parameter $X_p$ the system will become less and less accurate in predicting the correct voltage relaxation end value, i.e. the EMF.

US-A-6,366,054 (Hoenig et al) discloses a voltage-prediction model based on the measured battery OCV, the change in measured battery OCV over time (dOCV/dt), and the temperature measured at any time during the voltage relaxation process. The invention is described in relation to lead-acid storage batteries having a number of cells sufficient to produce a rated voltage of 24 V. However, applicability to other battery chemistries is claimed as well. In order to find the correct parameters for the system, the battery is charged and discharged in fixed steps, starting from an empty battery. Each time the charge or discharge current is interrupted a set of three parameters is measured and recorded as data points until the battery voltage/OCV has stabilized. These parameters include the battery voltage (OCV), the rate of change of the battery OCV and the temperature. Battery OCV and temperature are taken as instantaneous measurements, while the rate of change of OCV is measured over a predetermined time period, e.g. 30 seconds. Note again that this prior art method makes use of fixed parameters which have been obtained from a laboratory experiment. When these parameters are stored in the system and the battery characteristics change, which will always happen due to ageing, the accuracy of the predicted voltage relaxation end values will decrease over time.

In summary, the main problem with the SoC indication method described in US-A-6 515 453 is the accurate determination of battery equilibrium. Of the available methods to determine the equilibrium voltage of the battery after relaxation, the use of a voltage-prediction model seems the most attractive. However, the methods currently known in the literature make use of fixed parameters in the prediction of the voltage relaxation end value, which is a disadvantage, since changing battery characteristics due to aging will lead to decreasing prediction accuracy over time.

EP 1 643 260 A1 discloses a method for calculating charged rate of a secondary battery.

SUMMARY OF THE INVENTION

To avoid these problems the present invention provides a method for determining the state-of-charge (SoC) of a battery which has been charged or discharged and which has not reached its equilibrium state, the method comprising the steps of determining the EMF of the battery by extrapolation of the battery voltage sampled during relaxation after the charge or the discharge process, wherein the extrapolation is based on a extrapolation model using only variables sampled during the relaxation process and deriving the state-of-charge (SoC) of the battery from the EMF of the battery by using a predetermined relation between the EMF and the state-of-charge (SoC) of the battery, wherein after the end of the charge or discharge process the battery voltage is measured at least four times during the relaxation process and the extrapolation model uses at least four sampled voltage values resulting from the said measurements,

- wherein the extrapolation is executed by using a model described by the formula:

$$V_t = V_\infty - \frac{\Gamma\gamma}{t^\alpha \log^\delta(t)} e^{\varepsilon_t/2}$$

wherein parameters $\gamma > 0$, $\alpha > 0$, $\delta > 0$ are the rate-determining constants, $\Gamma$ is equal to +1 if the voltage is rising, after a discharge step and equal to -1 if the voltage is decreasing, after a charge step, $V_\infty$ is the final relaxation voltage (the EMF), $V_t$ is the relaxation voltage at time t, $\log^\delta(t)$ is the natural logarithm (with base e) of time to the power of parameter $\delta$ and $\varepsilon_t$ is a random error term.

This method is a voltage-prediction method without the need to store parameters beforehand. Instead, the voltage relaxation end value is determined based on the measured first part of a voltage relaxation curve and mathematical optimisation/fitting of a function to this measured part of the relaxation curve. In addition to the unknown voltage relaxation end value, the function contains some more parameters that are also found by fitting. This means that these parameters are updated for each individual situation, without the need to store values beforehand. Thus no previously stored parameters are used such as the prior-art methods do, making the method better suitable to deal with battery aging than the prior-art voltage-prediction methods.

Another advantage of this method is that the EMF can be predicted with enough accuracy in the first few minutes after current interruption. Further it improves the prior-art SoC indication algorithm, since it gives more calibration opportunities and solves the problem of not being able to exactly determine battery equilibrium. It also leads to an improvement of any SoC indication system based on the EMF method.

The method can be described as follows. At the beginning of the relaxation process the actual open-circuit voltage of the battery does not coincide with the EMF. The reason of this difference is the overpotential built-up during the preceding (dis)charge period. This overpotential makes the battery voltage during the (dis)charge process deviate from the EMF. The overpotential build-up is caused by various electrochemical processes that occur in the battery, such as Li+-ion diffusion in both electrodes, diffusion and migration of Li+ and other ions in the electrolyte, Butler-Volmer kinetic limitations on the surfaces of electrodes, etc. For that reason the relaxation process is, in general, a complex function of various factors such as the SoC, amount of charge added or removed from the battery, temperature and aging. That large amount of dependencies makes it difficult to predict the EMF at the very beginning of the relaxation period. Therefore, the relaxation process during a certain period of time should be observed in order to be able to give an accurate prediction of the final EMF value.

Denote $t_i$ as the moments in time at which the battery voltages $V_{ti}$ are observed during the relaxation process. This implies that the first part of the relaxation curve is sampled with N sample points (ti, Vti). The general model for the voltage relaxation that is proposed in this ID is given by the following equation:

$$V_t = V_\infty - \frac{\Gamma\gamma}{t^\alpha \log^\delta(t)} e^{\varepsilon_t/2}$$

where parameters $\gamma > 0$, $\alpha > 0$, $\delta > 0$ are the rate-determining constants, r is equal to +1 if the voltage is rising, after a discharge step and equal to -1 if the voltage is decreasing, after a charge step, $V_\infty$ is the final relaxation voltage (an asymptotical value, i.e. EMF), $V_t$ is the relaxation voltage at time t, $\log^\delta(t)$ is the natural logarithm (with base e) of time to the power of parameter $\delta$ and $\varepsilon_t$ is a random error term. Note that this model assumes an exponential multiplicative error structure.

The parameters $V_\infty$, $\alpha$, $\delta$ and $\gamma$ can be estimated by applying the concentrated Ordinary Least Squares (OLS) scheme. Therefore, the above equation can be re-written by taking square values:

$$\left( \Gamma \frac{\gamma}{t^{\alpha} \log^{\delta}(t)} \right)^2 e^{\varepsilon_t} = \left( V_{\infty} - V_t \right)^2$$

Taking logarithmic values with base e, this equation can be reduced to a usual regression model:

$$\log(V_{\infty} - V_t)^2 = C + A \log(t) + D \log(\log(t)) + \varepsilon_t$$

with $\Gamma^2 = 1$ for both charging and discharging, and $C = 2\log(\gamma)$, $A = -2\alpha$ and $D = -2\delta$. For each fixed value of $V_{\infty}$ this equation expresses the usual regression model with relaxation voltage samples $V_{ti}$ at discrete time instants $t_1..t_N$:

$$y_t = x_t' \beta + \varepsilon_t, \quad t = t_1, \ldots, t_N$$

where $y_{ti} = \log(V_{\infty} - V_{ti})^2$, $x_{ti} = (1, \log(t_i), \log(\log(t_i)))'$, $\beta = (C, A, D)'$, i= 1..N. In matrix notations it is written as

$$y = X\beta + \varepsilon$$

where $y = (y_1, ..., y_N)'$, $\varepsilon = (\varepsilon_1, ..., \varepsilon_N)'$ and $X = (x_1, ..., x_N)'$, is a matrix of regressors based on N available time instants $t_i$, i.e. the columns in this matrix are formed by ones, $\log(t_i)$-values and $\log(\log(t_i))$-values. After obtaining the initial OLS estimator for $\beta$, i.e. $\hat{\beta} = (\hat{C}, \hat{A}, \hat{D})'$, where $\hat{\beta} = (X'X)^{-1}X'y$, based on an initial guess for $V_{\infty}$ used to calculate y, $\|y - X\hat{\beta}\|^2$ is calculated and minimized with regard to $V_{\infty}$ (where the OLS estimator $\beta$ is recalculated each time $V_{\infty}$ is changed). This leads to a simpler implementation than minimizing Eq. 11 with regard to $V_{\infty}$ and $\beta$. The initial guess of $V_{\infty}$ can e.g. be obtained by adding 100 mV to the first voltage sample in case of relaxation after a discharge step, or by subtracting 100 mV in the case of relaxation after a charge step. Finally, the parameters in original model of Eq. 1 will be recovered as $\hat{\gamma} = \exp(\hat{C}/2)$. $\hat{\alpha} = -\hat{A}/2$, $\hat{\delta} = -\hat{D}/2$. In summary, the voltage-prediction model of Eq. 1 is fitted to the measured relaxation curve described by sample points $(t_i, V_{ti})$, i=1..N. This yields a predicted relaxation voltage curve and a predicted relaxation end voltage $V_{\infty}$. Since there are 4 unknown parameters in the model of Eq. 1 ($V_{\infty}, \alpha, \delta, \gamma$) at least 4 sample points are needed to be able to solve the set of equations, i.e. N≥4.

A further preferred embodiment provides such a method, wherein at least some of the samples result from the multiple measurements of the voltage subjected to low-pass filtering by averaging. It has appeared to the inventors that the open-circuit voltage measured in accordance with the invention may be subject to voltage spikes and other short transients. By averaging the results of groups of measurements the effects of such spikes are minimized.

Preferably the samples of the voltage used in the extrapolation process are taken within six minutes after the end of the charge or the discharge process. As stated beforehand the inventions aims to provide an accurate prediction of the EMF from measurements taken shortly after the charge or discharge process. It appears that when the measurements are taken in the first six minutes of the relaxation process, accurate results are obtained for fresh and aged batteries, leading to the advantage that the EMF and hence the SoC can be determined with accuracy within a short time. Although the indicated six minutes give adequate results, it is very well conceivable that - possibly in dependence of the type of battery - adequate results may be obtained when the measurements are taken within other time durations at the start of the relaxation process, like within the first three, four minutes or five minutes or within the first eight, ten, twelve or fifteen minutes. Generally the results will be better when more measurements are taken.

The open-circuit voltage measured during the relaxation process results from a number of processes taking place simultaneously. It has appeared that during the first half minute after the end of the discharge process, the measured voltage is the result of even more complicated processes. Hence the formula used in the interpolation process according to the invention is less applicable during this first half minute. The use of measuring values taken during this initial time, would consequently lead to less accurate results. By starting the measuring only after this period, more accurate results can be obtained. A preferred embodiment provides such a method, wherein the first sample used in the extrapolation process is taken more than half a minute after the end of the discharge process. However instead of half a minute, other times may be used like 10 seconds, one minute or two minutes. The choice of the time depends on the properties of the battery and more in particular of the duration of the relaxation process. There is also a relation between the time after the charge or discharge process when the first measurement is taken and the duration within which the following measurements are taken; the longer the first measurement is postponed to avoid the influence of relaxation processes, the higher the need is to prolong the time for following measurements to obtain a required accuracy.

Similarly it has appeared that during the first half minute after the end of the charge process, the measured voltage is the result of even more complicated processes. Hence the formula used in the interpolation process according to the invention is less applicable during the first half minute. The use of measuring values taken during this initial time, would consequently less to less accurate results. By starting the measuring only after this period, more accurate results can be obtained. A preferred embodiment provides such a method, wherein the first sample used in the extrapolation process is taken more than half a minute after the end of the charge process. However instead of half a minute, other times may be used like 10 seconds, one minute or two minutes.

In yet another preferred embodiment the extrapolation model used for the determination of the EMF of the battery is also used to determine the time after which the battery voltage has reached the EMF. In some instances it may be interesting to determine how much time it takes before the open battery voltage reaches the EMF, for instance in battery management. A specific preferred embodiment provides such a method wherein the extrapolation model used for the determination of the EMF of the battery is also used to determine the time after which the battery voltage has reached the EMF.

The time obtained with the method mentioned above may be used in a process to adapt or recalibrate the formula used in the determination of the EMF. A preferred embodiment provides the feature that the value of the EMF determined by the extrapolation process is compared with the EMF value measured after the time determined in the method as claimed in claim 8, and wherein the model is adapted by increasing the number of measurements or by amending the time between the end of the charge or discharge process and the first measurement when the difference between the measured value and the extrapolated value of the EMF is greater than a predetermined value. Herein is noted that it is not the parameters in Eq. 1 that are adapted, but rather the number of measurements and the times when these measurements are taken, i.e. the part of the relaxation curve taken into account in the fitting process.

As stated before, the main aim of the invention is to provide an accurate indication of the state-of-charge of a battery. However users are often more interested in the time left they can use the appliance before the battery is exhausted. Therefore a preferred embodiment of the invention mentions a method, wherein the remaining time of use left is calculated under the present discharge conditions.

The method disclosed in this document is directed to the determination of the EMF and hence of the state-of-charge of a battery during those times wherein no charging or discharging takes place and during which equilibrium has not yet been reached. It may however very well perform its function in an integrated system which is equipped for determination of the EMF and the state-of-charge when the battery is in equilibrium and the determination of the state-of-charge in situations wherein the battery is charged or discharged. Hence the invention relates also to a method for determining the state-of-charge (SoC) of a battery which is subjected to charge and discharge processes and idle times during which no charge or discharge processes take place wherein the state-of-charge during periods after a charge or discharge process is determined in accordance with a method according to one of the preceding claims.

The method as describe above is preferably implemented in an apparatus for determining the state-of-charge (SoC) of a battery which has been charged or discharged and which has not reached its equilibrium state, the apparatus comprising measuring means for measuring the open voltage of the battery during relaxation after the charge or the discharge process, calculating means for determining the EMF by extrapolation of the measured values op the open voltage of the battery, wherein the calculating means are adapted to execute extrapolation based on a extrapolation model using only variables measured after the end of the charge or discharge process and means for deriving the state-of-charge (SoC) of the battery from the EMF of the battery by using a predetermined relation between the EMF and the state-of-charge (SoC) of the battery, wherein the calculation means are adapted to execute the extrapolation by using a model described by the formula:

$$V_t = V_\infty - \frac{\Gamma\gamma}{t^\alpha \log^\delta(t)} e^{\varepsilon_t/2} V_\infty$$

wherein parameters $\gamma > 0, \alpha > 0, \delta > 0$ are the rate-determining constants, r is equal to +1 if the voltage is rising, after a discharge step and equal to -1 if the voltage is decreasing, after a charge step, $V_\infty$ is the final relaxation voltage (the EMF), $V_t$ is the relaxation voltage at time t, $\log^\delta(t)$ is the natural logarithm (with base e) of time to the power of parameter $\delta$ and $\varepsilon_t$ is a random error term.

The apparatus may preferably be implemented in a battery charge apparatus or in an electric device adapted to by supplied by power by a battery.

Such an electric device may be formed by a portable electronic device, like a mobile telephone, a GPS-device, or a shaver, but it may very well be formed by an electrically driven vehicle, like a hybrid vehicle, comprising a traction battery, wherein the apparatus is adapted to determine the state-of-charge of the traction battery.

BRIEF DESCRIPTION OF THE DRAWINGS

Subsequently the invention will be elucidated with the help of the accompanying drawings, wherein:

Fig. 1 is a graph showing the voltage relaxation after a discharge current step;
Fig. 2 is a diagram showing an embodiment of the invention;
Fig. 3 is a flow chart of the method according to the invention;
Fig. 4 is a diagram of a further embodiment of the invention;
Fig. 5-10 are graphs showing the error in the SoC estimation of the method of the invention under different situations.

DETAILED DESCRIPTION OF THE EMBODIMENTS

As described in the previous sections the newly proposed voltage-prediction model can be used advantageously in the prior-art SoC indication algorithm disclosed in US-A-6 420 851 and US-A-6 515 453. However, it can also be used in any SoC indication method in which the EMF of the battery is used to determine the SoC. For example, in the past many SoC systems designed for lead-acid batteries made use of the linear relationship between the lead-acid-battery EMF and SoC. As soon as a charge or discharge current is interrupted, the method allows determining the EMF quickly, i.e. in a few minutes, based on measured voltage samples from the battery relaxation curve.

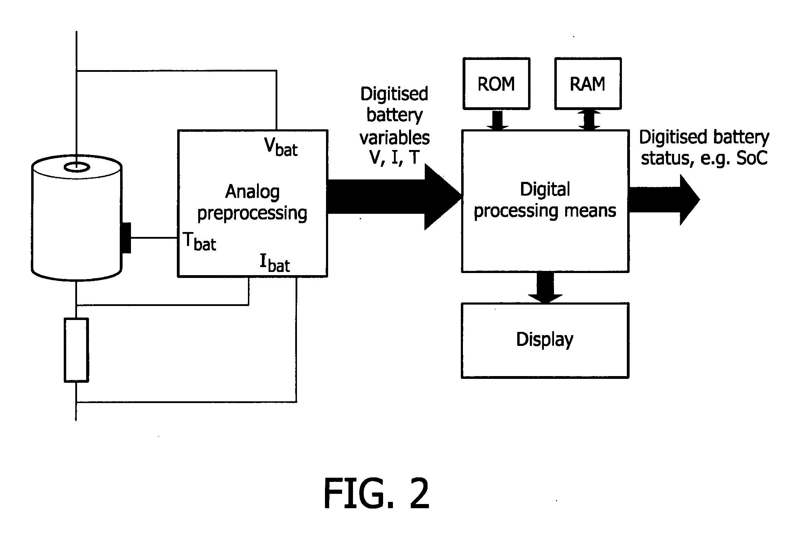

A general block diagram of how the voltage-prediction method may be implemented in an SoC indication system is given in Fig. 2. The battery voltage $V_{bat}$, current $I_{bat}$ and temperature $T_{bat}$ are measured by means of an analog pre-processing unit, including e.g. filtering, amplification and digitisation. Digital representations of the battery variables are fed to a digital processing means, such as a micro-controller. The voltage-prediction method as well as any SoC indication system based on the EMF method runs on this digital processing unit. The unit also makes use of memory, which can be external memory or memory present on the same silicon die. ROM memory is used to store battery-specific data beforehand, such as the EMF curve, possibly as a function of temperature. The RAM is used to write temporary data to or to store battery history information. For example, the first part of the voltage relaxation curve may be stored in this RAM memory and the digital processing means may then obtain samples from this RAM memory and use them in the curve-fitting or linear-regression method to fit parameters $V_\infty$, $\alpha$, $\delta$, and $\gamma$ of Eq. 1 such that the model fits the first part of the relaxation curve. Parameter $V_\infty$ can then be used in the SoC indication algorithm to obtain an SoC value via the EMF curve stored in the ROM. The predicted SoC value may be shown directly to the user via a display or may be communicated elsewhere via a digital interface. For example, the latter situation may occur when the digital processing means depicted in Fig. 2 is present in a dedicated SoC indication IC that transmits SoC data to the host processor of the portable device.

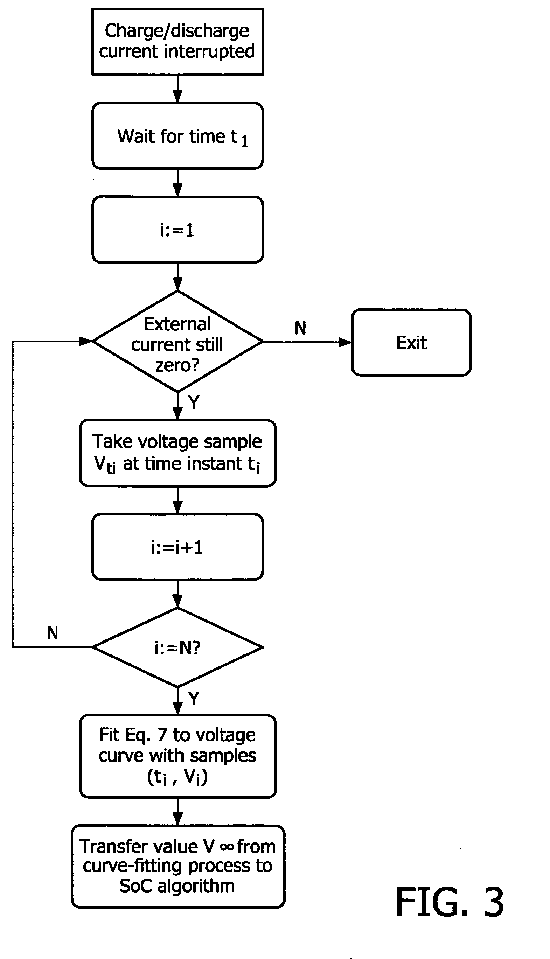

A possible way of programming the voltage-prediction method into the digital processing means in Fig. 2 is illustrated in the form of a flow diagram in Fig. 3. The algorithm is started when a charge or discharge current is interrupted. This can be inferred from the measured value of the current becoming zero. When this happens, first a wait cycle of duration t1 is started to make sure that the steepest part of the relaxation curve, corresponding to the fastest time constants in the battery, has elapsed. As mentioned in the previous section, time $t_1$ can be made dependent on whether a charge or a discharge has been interrupted and can be e.g. half a minute for interrupted discharges and charges. Other values can also be thought of, dependent on the used battery type.

When time $t_1$ has elapsed a number of N voltage samples $V_{ti}$ at times $t_i$ are taken, with i running from 1 to N, under the condition that the externally applied current remains zero. With the first part of the relaxation curve being recorded, the curve-fitting process of Eq. 1 can be started, e.g. by means of the fitting process described earlier. Several possibilities exist here. For example, based on the values of the time samples $t_i$, regression matrix X can be calculated and stored in memory (RAM). This leads to an increased speed of the fitting process. Alternatively, the elements of matrix X may be calculated at the moment when they are needed in the form of $\log(t_i)$ and $\log(\log(t_i))$ as described earlier, which leads to less occupied memory space.

When the fitting process is finished, the parameters $V_\infty$, $\alpha$, $\delta$, and $\gamma$ of Eq. 1 are known.

As shown in Fig. 3, the value of $V_\infty$ can be directly communicated to the SoC algorithm, where it can be translated into a predicted SoC value based on the EMF curve. Alternatively, as an accuracy check of the fitting process, the algorithm can wait and take some more voltage samples that can be compared to voltage values calculated with the fitted curve at the corresponding time instants. When enough voltage points have been checked the value of $V_\infty$ can be transferred to the SoC indication algorithm. From time to time, the algorithm may even be checked completely by waiting until the voltage has indeed stabilized to verify the predicted value of $V_\infty$. For example, after the fitting process the algorithm can calculate how much time it will take to reach $V_\infty$ within a specified range. The algorithm can then wait for that time, without taking additional samples, and then sampling the voltage once or a few times after this time period to verify the accuracy of the predicted V∞ value. This accuracy check of the voltage-prediction algorithm may be performed at specified intervals, e.g. every tenth voltage relaxation process, or each time the battery indeed gets the time to relax for the projected time. The outcome may be used to tune the parameters $t_1$ and N, i.e. the part of the relaxation curve used for fitting.

As a final embodiment, the voltage-prediction model, e.g. implemented as shown in Fig. 3, can also be embedded in the SoC indication algorithm of patent US-A-6 420 453. The state diagram of that patent is repeated here for reference, without a repeat of a detailed explanation of each transfer between states.

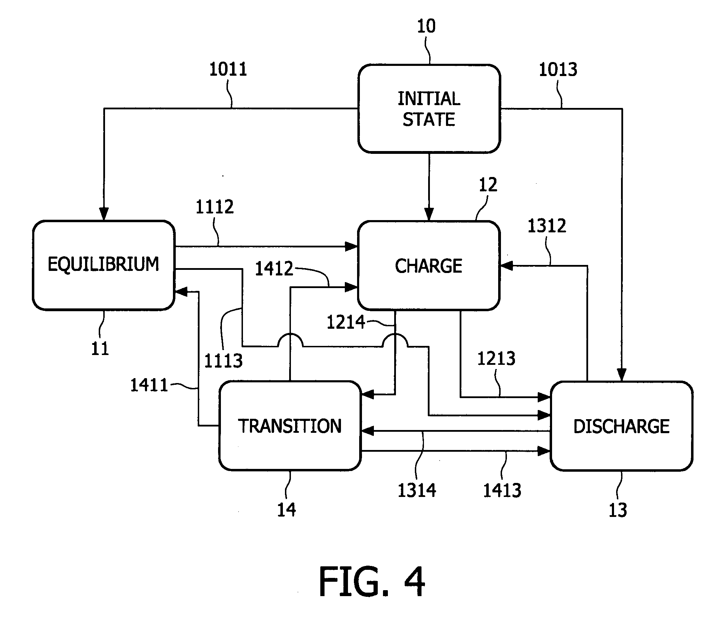

In figure 4 a flow diagram is shown wherein the algorithm of the invention is incorporated into the algorithm described in US6,515,453. In the transition state, the logarithm determines whether the battery voltage is stable, according to US-A-6 515 453 . Alternatively, the voltage-prediction method e.g. as implemented in Fig. 3 may be used when the transition state is entered. As soon as the value of $V_\infty$ is available, i.e. after a few minutes of relaxation, its value can be transferred to the equilibrium state, in which it is used in the EMF method to predict the SoC to calibrate the system.

Results obtained with new voltage-prediction model

In order to test the accuracy of the voltage-prediction model a Li-ion US 18500G3 battery (rated capacity 1100 mAh) has been charged and discharged using a Maccor battery tester in steps of 50 mAh at different C-rates (0.05 C-rate, 0.1 C-rate, 0.25 C-rate, 0.5 C-rate) and at different temperatures (25 and 45°C, respectively). After each charge or discharge step the battery voltage has been allowed to relax fully using long relaxation times. Based on the first part of the relaxation curve, the model has been used to predict the voltage relaxation end value. This value has been compared with the measured voltage end value obtained after long relaxation. In order to have useful results of the voltage-prediction model for application in the SoC indication method of US-A-6515 453, the error in SoC prediction based on the predicted EMF by the voltage-prediction model should be less than 1 %. First of all, it has been observed that the vertical shape of the relaxation process in the first moments of relaxation can give large inaccuracies in the predicted end-voltage value. In order to obtain an optimum value for the first sample time t1 that minimizes the error in the predicted voltage roughly 500 relaxation curves obtained with the Maccor battery tester, as described above, have been simulated with the model of Eq.1 using MATLAB. From these simulations it can be concluded that an optimum value for $t_1$ is half a minute for discharge and for charge. This means that after current interruption, at least the first half minute need to be ignored. Voltage samples used to fit the model of the equation to should be taken after this period of time.

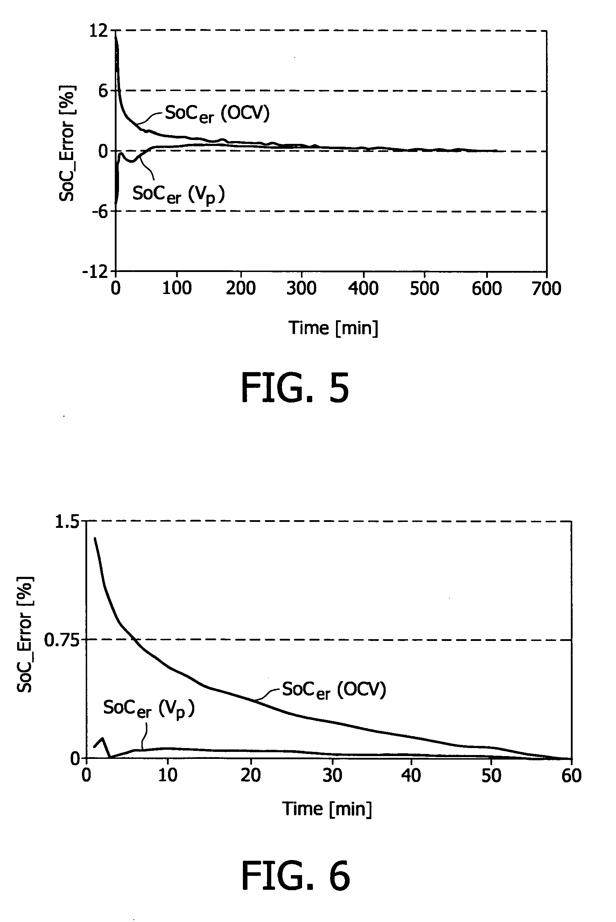

In order to further investigate the accuracy of the voltage-prediction model several measurements in a LabVIEW set-up have been performed, where an actual battery is charged and discharged and the end voltage after current interruption is estimated in real-time by the voltage model of Eq.1. The accuracy of the model has again been determined by comparing the SoC calculated with the EMF curve based on the predicted EMF voltage using the model of Eq. 1 with an SoC calculated based on a final EMF value obtained from the LabVIEW measurements, i.e. the final stabilized voltage after a long period of relaxation. The first minute of relaxation has been ignored in the model of the equation in case of a current interruption after discharge. The total relaxation period has been chosen such that under all conditions the battery is allowed to relax fully. Additionally, the SoC has also been determined using the EMF curve based on the instantaneous OCV values of the battery voltage during relaxation. As earlier, the error of this calculated SoC can be calculated by comparing it to the SoC based on the final EMF value measured at the battery terminals after a long relaxation time. This latter error gives an indication of the magnitude of the error one would get when using a fixed time for relaxation, after which the battery is considered to be in equilibrium. The resulting SoC errors when using the voltage-relaxation model of the equation or the instantaneous OCV value obtained for a discharge at 0.25 C-rate and 5 °C are plotted in Fig. 5.

Fig. 5 shows that the error in the SoC based on the voltage prediction ($SoC_{er}(Vp)$) is about 0.62% after five minutes of relaxation, whereas the SoC error when using the instantaneous OCV value $SoC_{er}(OCV)$ is about 6.16% at that time. An SoC error $SoC_{er}(OCV)$ of 0.6% is only obtained after a relaxation period of 260 minutes. From this it can be concluded that the voltage prediction offers a better accuracy after five minutes than the OCV of the battery considered after five minutes and it offers the same accuracy as when considering the OCV of a battery after 260 minutes of relaxation. The "speed" of the system based on EMF prediction and the voltage-relaxation model of Eq. 1 is improved 52 times in this situation (i.e. 260/5 = 52). This means that based on only the first five minutes of relaxation, ignoring the first minute, one can predict the SoC based on the EMF curve with the same accuracy as using a fixed relaxation time of 260 minutes. Moreover, it can be concluded from Fig. 5 that for the first 300 minutes the SoC values obtained based on the predicted voltage are more accurate than the SoC values obtained based on the OCV of the battery. After this point the two SoC values are more or less the same.

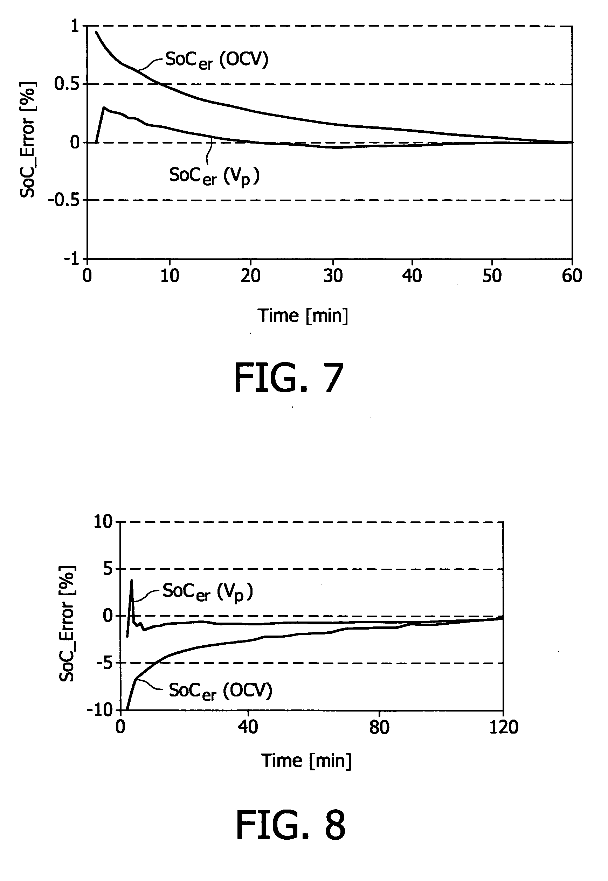

Other measurement results obtained after interrupting a discharge at 0.25 C-rate at 25 and 45 °C are presented in Figures 6 and 7. In both Fig. 6 and Fig. 7 the error $SoC_{er}(Vp)$ obtained when using voltage prediction by fitting the model of Eq.1 to the first part of the measured relaxation curve and using the predicted voltage in the EMF curve is smaller than the error $SoC_{er}(OCV)$ obtained by filling in the instantaneous OCV value in the EMF curve. For example, Fig. 7 shows that voltage prediction offers an error $SoC_{er}(Vp)$ of 0.3% when the first two minutes of the relaxation curve are considered, ignoring the first minute in the model fitting process, whereas $SoC_{er}(OCV)$ is 0.83% at that time. For this example the SoC obtained from voltage prediction using Eq.1 is more accurate during the complete relaxation time period. Hence, from the measurements presented so far it can be concluded that the voltage-prediction model performs better than just considering an OCV value and that generally an SoC error less than 1% is obtained after five minutes of relaxation.

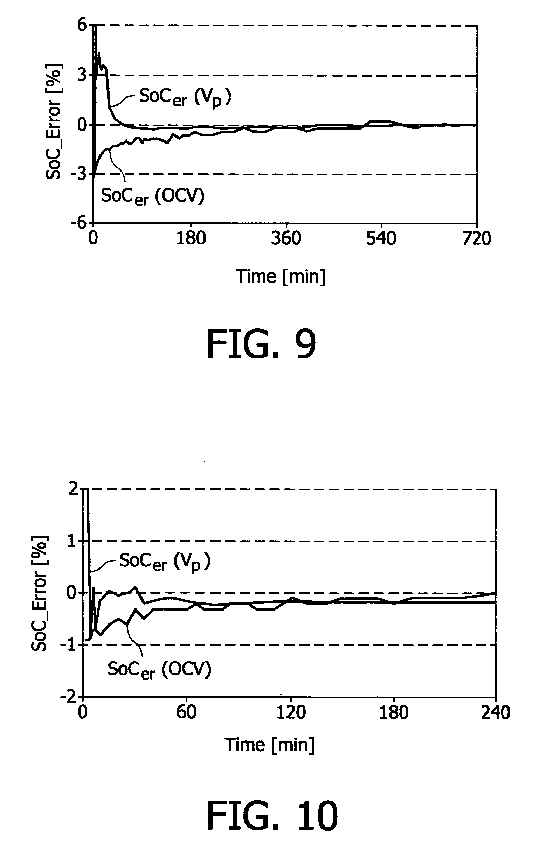

The same conclusions can be drawn from Fig. 8-10, in which the same curves are compared after applying a charge step with 0.25 C-rate at various temperatures. In this case, $SoC_{er}(Vp)$ has been obtained by fitting the model of the equation to the relaxation curve ignoring the first three minutes (which is larger than half a minute, the period which was defined earlier for charging as the time that should be ignored for good fitting).

For example, see Fig. 8 at a time of around four minutes. At this time, voltage prediction offers an error $SoC_{er}$ (Vp) of 0.5%, whereas the error $SoC_{er}(OCV)$ is 7.23 %. An error $SoC_{er}(OCV)$ of around 0.5% is obtained after a rest period of 110 minutes. Hence, voltage prediction offers a better accuracy than the OCV of the battery considered after four minutes and it offers the same accuracy as when considering the OCV after 110 minutes of relaxation. The "speed" of the system based on voltage relaxation model is improved in this situation 27 times (i.e. 110/4 =~ 27). Fig. 8 also shows that for the first 85 minutes the SoC values obtained based on the predicted voltage are more accurate than the SoC values obtained based on the OCV of the battery. After this point the two SoC values are more or less the same.

It can be concluded from Fig. 5-10 that the SoC calculated based on the predicted voltage after five minutes of relaxation at different SoC values, charge/discharge rates and temperatures offers an SoC prediction error smaller than 1.1 %. Compared to using a fixed relaxation time a considerable gain in speed is achieved, which means that after five minutes of relaxation the SoC of the battery can already be predicted with an error less than 1 % based on the EMF curve, while the battery voltage has not yet relaxed towards the EMF value.

The new method according to the invention of fitting the voltage-prediction model of Eq.1 on-line to the first part of the relaxation curve has also been compared to the prior-art voltage-prediction methods of Aylor and US-A-6 366 054. For the asymptotes system of Aylor the first voltage sample has been taken at 1 minute (X=0) and the second has been taken at 6.6 minutes (X=0.82). For the system based on OCV, dOCV/dt and temperature the same parameters as proposed in patent US-A-6 366 054 have been used, as well as OCV and dOCV/dt values at 6.6 minutes. The relaxation experiments used to draw Fig. 5 and Fig. 8 have been used. The results have been summarized in Table 1. Column one and two give the model name and the type of the previous step (Discharge or Charge). The equilibrium voltage VEMF and the predicted voltage Vp in [V] for each of the three models are given in column three and four respectively. Columns five and six denote the SoC indication calculated based on $V_{EMF}$ ($SoC_{true}$) and $V_p$ ($SoC_p$) respectively. Column seven denote the error in SoC calculated as the difference between the true and the predicted SoC value. Table 1. Models comparison results

Table 1. Models comparison results

| Model | Step | $V_{EMF}$ [V] | $V_p$ [V] | $SoC_{true}$ [%] | $SoC_p$ [%] | SoC_Error [%] |
|---|---|---|---|---|---|---|
| Asymptotes Aylor | Step D | 3.748 | 3.753 | 20.19 | 21.11 | -0.92 |
| | Step C | 3.88 | 3.887 | 61.56 | 62.54 | - 0.98 |
| Combined model US-A-6 366 054 | Step D | 3.748 | 2.56 | 20.19 | 0 | 20.19 |
| | Step C | 3.88 | 2.778 | 61.56 | 0 | 61.56 |
| New model This invention, Eq. 1 | Step D | 3.748 | 3.749 | 20.19 | 20.53 | -0.34 |
| | Step C | 3.88 | 3.884 | 61.56 | 62.21 | -0.65 |

Table 1 clearly shows that the SoC error is lower for the new method according to the invention than for the two prior-art systems. The asymptotes system of Aylor works remarkably well for this Li-ion battery experiment. However, it is based on a fixed parameter Xp, which will be different for other batteries of the same type and for older batteries. In fact, the new model also uses parameters $t_1$ and N that describe which part of the relaxation curve is used for fitting the equation. These parameters do not describe the actual relaxation curve but do influence the prediction accuracy. An advantage of the new model compared to the asymptotes method is that in addition to predicting the relaxation end voltage, the time it takes to reach this voltage is also predicted. This time can be used for tuning parameters $t_1$ and N of the model for optimum fitting accuracy. The combined method of US-A-6 366 054 does not work properly for this Li-ion battery experiment. Apparently, new parameters need to be used in the equations. Better results will probably be obtained when the model is fitted to this battery type, but even then the disadvantage remains that fixed parameter values are used.

Applications of the invention

The invention can be applied in portable battery-powered equipment, particularly for but not limited to Li-ion batteries. The invention can be used in conjunction with an SoC indication algorithm based at least partly on the EMF method and leads to accurate estimation of the battery SoC, even during aging of the battery.

**Claims**

1. Method of determining the state-of-charge (SoC) of a battery which has been charged or discharged and which has not reached its equilibrium state, the method comprising the following steps:

   - determining the EMF of the battery by extrapolation of the battery voltage sampled during relaxation after the charge or the discharge process, wherein the extrapolation is based on a extrapolation model using only variables sampled during the relaxation process; and
   - deriving the state-of-charge (SoC) of the battery from the EMF of the battery by using a predetermined relation between the EMF and the state-of-charge (SoC) of the battery, **characterised in that**
   - after the end of the charge or discharge process the battery voltage is measured at least four times during the relaxation process and the extrapolation model uses at least four sampled voltage values resulting from said measurements, and
   - the extrapolation is executed by using a model described by the formula:

   $$V_t = V_\infty - \frac{\Gamma \gamma}{t^\alpha \log^\delta(t)} e^{\varepsilon_t/2}$$

   wherein parameters $\gamma > 0, \alpha > 0, \delta > 0$ are the rate-determining constants, $\Gamma$ is equal to +1 if the voltage is rising, after a discharge step and equal to -1 if the voltage is decreasing, after a charge step, $V_\infty$ is the final relaxation voltage, i.e. the EMF, $V_t$ is the relaxation voltage at time t, $\log^\delta(t)$ is the natural logarithm of time to the power of parameter $\delta$ and $\varepsilon_t$ is a random error term.

2. Method as claimed in claim 1, wherein the first sample used in the extrapolation process is taken more than half a minute after the end of the charge or the discharge process.

3. Method as claimed in claim 1 or 2, wherein at least some of the samples result from the multiple measurements of the voltage subjected to low-pass filtering by averaging.

4. Method as claimed in any of the preceding claims, wherein the extrapolation model used for the determination of the EMF of the battery is also used to determine the time after which the battery voltage has reached the EMF.

5. Method as claimed in claim 4, wherein the value of the EMF determined by the extrapolation process is compared with the EMF value measured after the time determined in the method as claimed in claim 3, and wherein the model is adapted by increasing the number of measurements or by amending the time between the end of the charge or discharge process and the first measurement when the difference between the measured value and the extrapolated value of the EMF is greater than a predetermined value.

6. Method for determining the state-of-charge (SoC) of a battery which is subjected to charge and discharge processes and idle times during which no charge or discharge processes take place wherein the state-of-charge during periods after a charge or discharge process is determined in accordance with a method according to one of the preceding claims.

7. Apparatus for determining the state-of-charge (SoC) of a battery which has been charged or discharged and which has not reached its equilibrium state, comprising:

   - measuring means for measuring the open voltage of the battery during relaxation after the charge or the discharge process;
   - calculating means for determining the EMF by extrapolation of the measured values of the open voltage of the battery, wherein the calculating means are adapted to execute extrapolation based on an extrapolation model using only variables measured after the end of the charge or discharge process; and

- means for deriving the state- of- charge (SoC) of the battery from the EMF of the battery by using a predetermined relation between the EMF and the state- of- charge (SoC) of the battery **characterised in that** the calculation means are adapted to execute the extrapolation by using a model described by the formula:

$$V_t = V_\infty - \frac{\Gamma \gamma}{t^\alpha \log^\delta(t)} e^{\varepsilon_t/2} V_\infty$$

wherein parameters $\gamma > 0, \alpha > 0, \delta > 0$ are the rate-determining constants, r is equal to +1 if the voltage is rising, after a discharge step and equal to -1 if the voltage is decreasing, after a charge step, $V_\infty$ is the final relaxation voltage, i.e. the EMF, $V_t$ is the relaxation voltage at time t, $\log^\delta(t)$ is the natural logarithm of time to the power of parameter $\delta$ and $\varepsilon_t$ is a random error term.

8.  Apparatus as claimed in claim 7, wherein the measuring means are adapted to take the first sample used in the extrapolation process more than half a minute after the end of the charge or the discharge process.

9.  Apparatus as claimed in claim 7 or 8, wherein the measuring means are adapted to execute multiple measurements for each measured value and that the calculation means are adapted to average the measured voltages to obtain low-pass filtered measure values.

10.  Battery charge apparatus, comprising an apparatus for determining the state-of-charge (SoC) of a battery as claimed in one of the claims 7, 8 or 9.

11.  Electric device adapted to be supplied by power by a battery, comprising an apparatus as claimed in one of the claims 7, 8 or 9.

12.  Portable electronic device, like a mobile telephone, a GPS-device, or a shaver, comprising an apparatus as claimed in one of the claims 7, 8 or 9.

13.  Electrically driven vehicle, like a hybrid vehicle, comprising a traction battery and an apparatus as claimed in claim 7, 8 or 9, wherein the apparatus is adapted to determine the state-of-charge of the traction battery.

**Patentansprüche**

1.  Verfahren zur Bestimmung des Ladestatus einer Batterie, die aufgeladen oder entladen wurde und die nicht ihren Gleichgewichtszustand erreicht hat, wobei das Verfahren die folgenden Schritte umfasst:

    - Ermitteln der EMK der Batterie durch Extrapolation der während der Erholung nach dem Auflade- oder Entladevorgang erfassten Batteriespannung, wobei die Extrapolation auf einem Extrapolationsmodell basiert, das nur die während des Erholungsvorgangs erfassten Variablen verwendet; und
    - Ableiten des Batteriestatus der Batterie von der EMK der Batterie unter Verwendung eines vorgegebenen Verhältnisses zwischen der EMK und dem Ladestatus der Batterie, **dadurch gekennzeichnet, dass**
    - die Batteriespannung nach dem Ende des Auflade- oder Entladevorgangs mindestens während des Erholungsvorgangs mindestens vier Mal gemessen wird und das Extrapolationsmodell mindestens vier erfasste Spannungswerte verwendet, die aus den genannten Messungen resultieren, und
    - die Extrapolation unter Verwendung eines Modells ausgeführt wird, das durch die Formel

$$V_t = V_\infty - \frac{\Gamma \gamma}{t^\alpha \log^\delta(t)} e^{\varepsilon_t/2}$$

beschrieben wird, wobei die Parameter $\gamma > 0$, $\alpha > 0$, $\delta > 0$ die die Rate bestimmenden Konstanten sind, $\Gamma$ gleich +1

ist, wenn die Spannung nach einem Entladungsschritt ansteigt und -1 ist, wenn die Spannung nach einem Aufladungsschritt abnimmt, $V_\infty$ die endgültige Erholungsspannung, d.h. die EMK, ist, $V_t$ die Erholungsspannung zum Zeitpunkt t ist, $\log^\delta$ (t) der natürliche Logarithmus des Zeitpunktes hoch dem Parameter $\delta$ ist und $\varepsilon_t$ ein Zufallsfehler-Term ist.

2. Verfahren nach Anspruch 1, wobei der erste in dem Extrapolationsvorgang verwendete Abtastwert mehr als eine halbe Minute nach dem Ende des Auflade- oder Entladevorgangs erfasst wird.

3. Verfahren nach Anspruch 1 oder 2, wobei mindestens einige der Abtastwerte aus den mehreren Messungen der Spannung resultieren, welche einer Tiefpassfilterung durch Mittelwertbildung unterzogen wurden.

4. Verfahren nach einem der vorhergehenden Ansprüche, wobei das Extrapolationsmodell zur Ermittlung der EMK der Batterie auch verwendet wird, um die Zeit zu ermitteln, nach der die Batteriespannung die EMK erreicht hat.

5. Verfahren nach Anspruch 4, wobei der durch den Extrapolationsvorgang ermittelte Wert der EMK mit dem EMK-Wert verglichen wird, der nach der im Verfahren nach Anspruch 3 ermittelten Zeit gemessen wird, und wobei das Modell angepasst wird, indem die Anzahl der Messungen erhöht wird oder indem die Zeit zwischen dem Ende des Auflade- oder Entladevorgangs und der ersten Messung abgeändert wird, wenn die Differenz zwischen dem gemessenen Wert und dem extrapolierten Wert der EMK größer ist als ein vorgegebener Wert.

6. Verfahren zur Bestimmung des Ladestatus einer Batterie, die Auflade- und Entladevorgängen und Leerlaufzeiten unterzogen wird, während der keine Auflade- oder Entladevorgänge stattfinden, wobei der Ladestatus während Zeitspannen nach einem Auflade- oder Entladevorgang gemäß einem Verfahren nach einem der vorhergehenden Ansprüche bestimmt wird.

7. Gerät zur Bestimmung des Ladestatus einer Batterie, die aufgeladen oder entladen wurde und die ihren Gleichgewichtszustand nicht erreicht hat, wobei das Gerät Folgendes umfasst:

   - Messmittel zum Messen der Leerlaufspannung der Batterie während der Erholung nach dem Lade- oder Entladevorgang;
   - Berechnungsmittel zum Ermitteln der EMK durch Extrapolation der gemessenen Werte der Leerlaufspannung der Batterie, wobei die Berechnungsmittel vorgesehen sind, um die Extrapolation basierend auf einem Extrapolationsmodell durchzuführen, das nur die nach dem Ende des Auflade- oder Entladevorgangs gemessenen Variablen verwendet; und
   - Mittel zum Ableiten des Batteriestatus der Batterie von der EMK der Batterie unter Verwendung eines vorgegebenen Verhältnisses zwischen der EMK und dem Ladestatus der Batterie, **<u>dadurch gekennzeichnet, dass</u>** die Berechnungsmittel vorgesehen sind, um die Extrapolation unter Verwendung eines Modells durchzuführen, das durch die Formel

$$V_t = V_\infty - \frac{\Gamma\gamma}{t^\alpha \log^\delta(t)} e^{\varepsilon_t/2}$$

beschrieben wird, wobei die Parameter $\gamma > 0$, $\alpha > 0$, $\delta > 0$ die die Rate bestimmenden Konstanten sind, $\Gamma$ gleich +1 ist, wenn die Spannung nach einem Entladungsschritt ansteigt und -1 ist, wenn die Spannung nach einem Aufladungsschritt abnimmt, $V_\infty$ die endgültige Erholungsspannung, d.h. die EMK, ist, $V_t$ die Erholungsspannung zum Zeitpunkt t ist, $\log^\delta$ (t) der natürliche Logarithmus des Zeitpunktes hoch dem Parameter $\delta$ ist und $\varepsilon_t$ ein Zufallsfehler-Term ist.

8. Gerät nach Anspruch 7, wobei die Messmittel vorgesehen sind, um den ersten in dem Extrapolationsvorgang verwendeten Abtastwert mehr als eine halbe Minute nach dem Ende des Auflade- oder Entladevorgangs zu erfassen.

9. Gerät nach Anspruch 7 oder 8, wobei die Messmittel vorgesehen sind, um mehrere Messungen für jeden gemessenen Wert durchzuführen und die Berechnungsmittel vorgesehen sind, um die gemessenen Spannungen zu mitteln, um tiefpassgefilterte Messwerte zu erhalten.

10. Batterieladegerät mit einem Gerät zur Bestimmung der Ladestatus einer Batterie nach einem der Ansprüche 7, 8 oder 9.

**11.** Elektrische Vorrichtung, die vorgesehen ist, um mit Batteriestrom versorgt zu werden und die ein Gerät nach einem der Ansprüche 7, 8 oder 9 umfasst.

**12.** Tragbare elektronische Vorrichtung, zum Beispiel ein Mobiltelefon, eine GPS-Vorrichtung oder ein Rasierer, mit einem Gerät nach einem der Ansprüche 7, 8 oder 9.

**13.** Elektrisch angetriebenes Fahrzeug, zum Beispiel ein Hybridfahrzeug, mit einer Traktionsbatterie und einem Gerät nach Anspruch 7, 8 oder 9, wobei das Gerät vorgesehen ist, um den Ladestatus der Traktionsbatterie zu bestimmen.

## Revendications

**1.** Procédé pour déterminer l'état de charge (SoC) d'une batterie qui a été chargée ou déchargée et qui n'a pas atteint son état d'équilibre, le procédé comprenant les étapes consistant à :

- déterminer la FEM de la batterie par extrapolation de la tension de batterie échantillonnée pendant la relaxation après le processus de charge ou de décharge, l'extrapolation étant basée sur un modèle d'extrapolation utilisant uniquement les variables échantillonnées pendant le processus de relaxation ; et
- dériver l'état de charge (SoC) de la batterie de la FEM de la batterie en utilisant une relation prédéterminée entre la FEM et l'état de charge (SoC) de la batterie, **caractérisé en ce que**
- une fois le processus de charge ou de décharge terminé, la tension de batterie est mesurée au moins quatre fois pendant le processus de relaxation et le modèle d'extrapolation utilise au moins quatre valeurs de tension échantillonnées résultant desdites mesures, et
- l'extrapolation est exécutée en utilisant un modèle décrit par la formule :

$$V_t = V_\infty - \frac{\Gamma \gamma}{t^\alpha \log^\delta(t)} e^{\varepsilon_t / 2}$$

dans laquelle les paramètres $\gamma > 0$, $\alpha > 0$, $\delta > 0$ sont les constantes de détermination de taux, $\Gamma$ est égal à +1 si la tension est croissante, après une étape de décharge et égal à -1 si la tension est décroissante, après une étape de charge, $V_\infty$ est la tension de relaxation finale, à savoir la FEM, $V_t$ est la tension de relaxation à l'instant t, $\log^\delta$ (t) est le logarithme naturel du temps à la puissance du paramètre $\delta$ et $\varepsilon_t$ est un terme d'erreur aléatoire.

**2.** Procédé selon la revendication 1, dans lequel le premier échantillon utilisé dans le processus d'extrapolation est prélevé plus d'une demi-minute après la fin du processus de charge ou de décharge.

**3.** Procédé selon la revendication 1 ou 2, dans lequel au moins certains des échantillons résultent des multiples mesures de la tension soumise au filtrage passe-bas par moyennage.

**4.** Procédé selon l'une quelconque des revendications précédentes, dans lequel le modèle d'extrapolation utilisé pour la détermination de la FEM de la batterie est également utilisé pour déterminer le temps au bout duquel la tension de batterie a atteint la FEM.

**5.** Procédé selon la revendication 4, dans lequel la valeur de la FEM déterminée par le processus d'extrapolation est comparée à la valeur de la FEM mesurée après le temps prédéterminé dans le procédé selon la revendication 3, et dans lequel le modèle est adapté en augmentant le nombre de mesures ou en modifiant le temps entre la fin du processus de charge ou de décharge et la première mesure lorsque la différence entre la valeur mesurée et la valeur extrapolée de la FEM est supérieure à une valeur prédéterminée.

**6.** Procédé pour déterminer l'état de charge (SoC) d'une batterie qui est soumise aux processus de charge et de décharge et les temps de repos pendant lesquels n'a lieu aucun processus de charge ou de décharge, dans lequel l'état de charge pendant les périodes après un processus de charge ou de décharge est déterminé conformément à un procédé selon une des revendications précédentes.

**7.** Appareil pour déterminer l'état de charge (SoC) d'une batterie qui a été chargée ou déchargée et qui n'a pas atteint son état d'équilibre, comprenant :

- des moyens de mesure pour mesurer la tension ouverte de la batterie pendant la relaxation après le processus de charge ou de décharge ;
- des moyens de calcul pour déterminer la FEM par extrapolation des valeurs mesurées de la tension ouverte de la batterie, les moyens de calcul étant conçus pour exécuter l'extrapolation sur la base d'un modèle d'extrapolation en utilisant uniquement les variables mesurées une fois le processus de charge ou de décharge terminé ; et
- des moyens pour dériver l'état de charge (SoC) de la batterie de la FEM de la batterie en utilisant une relation prédéterminée entre la FEM et l'état de charge (SoC) de la batterie, **caractérisé en ce que** les moyens de calcul sont conçus pour exécuter l'extrapolation en utilisant un modèle décrit par la formule :

$$V_t = V_\infty - \frac{\Gamma \gamma}{t^\alpha \log^\delta(t)} e^{\varepsilon_t/2} V_\infty$$

dans laquelle les paramètres $\gamma > 0$, $\alpha > 0$, $\delta > 0$ sont les constantes de détermination de taux, $\Gamma$ est égal à +1 si la tension est croissante, après une étape de décharge et égal à -1 si la tension est décroissante, après une étape de charge, $V_\infty$ est la tension de relaxation finale, à savoir la FEM, $V_t$ est la tension de relaxation à l'instant t, $\log^\delta(t)$ est le logarithme naturel du temps à la puissance du paramètre $\delta$ et $\varepsilon_t$ est le terme d'erreur aléatoire.

**8.** Appareil selon la revendication 7, dans lequel les moyens de mesure sont conçus pour prélever le premier échantillon utilisé dans le processus d'extrapolation plus d'une demi-minute après la fin du processus de charge ou de décharge.

**9.** Appareil selon la revendication 7 ou 8, dans lequel les moyens de mesure sont conçus pour exécuter de multiples mesures pour chaque valeur mesurée et les moyens de calcul sont conçus pour moyenner les tensions mesurées pour obtenir des valeurs de mesure soumises à un filtrage passe-bas.

**10.** Appareil de charge de batterie, comprenant un appareil pour déterminer l'état de charge (SoC) d'une batterie selon une des revendications 7, 8 ou 9.

**11.** Dispositif électrique conçu pour être alimenté en énergie par une batterie, comprenant un appareil selon une des revendications 7, 8 ou 9.

**12.** Dispositif électronique portable, tel qu'un téléphone mobile, un dispositif GPS, ou un rasoir, comprenant un appareil selon une des revendications 7, 8 ou 9.

**13.** Véhicule à fonctionnement électrique, tel qu'un véhicule hybride, comprenant une batterie de traction et un appareil selon la revendication 7, 8 ou 9, dans lequel l'appareil est conçu pour déterminer l'état de charge de la batterie de traction.

FIG. 1

FIG. 2

Charge/discharge current interrupted

Wait for time $t_1$

i:=1

External current still zero? — N → Exit

Y

Take voltage sample $V_{ti}$ at time instant $t_i$

i:=i+1

i:=N? — N

Y

Fit Eq. 7 to voltage curve with samples $(t_i, V_i)$

Transfer value $V_\infty$ from curve-fitting process to SoC algorithm

FIG. 3

FIG. 4

EP 2 089 731 B1

FIG. 5

FIG. 6

FIG. 7

FIG. 8

FIG. 9

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6420851 A
- US 6515453 A
- WO 2005085889 A
- US 6366054 A, Hoenig
- EP 1643260 A1
- US 6420453 A
- US 6515453 B
- US 18500G3 A

**Non-patent literature cited in the description**

- Battery Management Systems - Design by Modelling. **H. J. Bergveld ; W. S. Kruijt ; P. H. L. Notten.** Philips Research Book Series. Kluwer Academic Publishers, 2002, vol. I
- **J.H. Aylor ; A. Thieme ; B.W. Johnson.** A Battery State-of-Charge Indicator for Electric Wheelchairs. *IEEE Trans. on industrial electronics,* October 1992, vol. 39 (5), 398-409